(19) Europäisches Patentamt
European Patent Office
Office européen des brevets

(11) **EP 2 832 537 B1**

(12) **EUROPEAN PATENT SPECIFICATION**

(45) Date of publication and mention
of the grant of the patent:
**08.05.2019 Bulletin 2019/19**

(51) Int Cl.:
**C23C 14/58** (2006.01)    **C23C 14/10** (2006.01)
**C23C 16/30** (2006.01)    **C23C 28/04** (2006.01)

(21) Application number: **13769734.8**

(86) International application number:
**PCT/JP2013/059460**

(22) Date of filing: **29.03.2013**

(87) International publication number:
**WO 2013/147119 (03.10.2013 Gazette 2013/40)**

(54) **GAS-BARRIER FILM AND PROCESS FOR PRODUCING SAME, AND GAS-BARRIER LAMINATE**

GASSPERRFOLIE UND HERSTELLUNGSVERFAHREN DAFÜR SOWIE GASSPERRLAMINAT

FILM BARRIÈRE AUX GAZ ET SON PROCÉDÉ DE FABRICATION, ET STRATIFIÉ À BARRIÈRE AUX GAZ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.03.2012 JP 2012082915**

(43) Date of publication of application:
**04.02.2015 Bulletin 2015/06**

(73) Proprietor: **Mitsubishi Chemical Corporation Tokyo 100-8251 (JP)**

(72) Inventors:
• **SUGITA, Kentarou**
  **Ushiku-shi**
  **Ibaraki 300-1201 (JP)**
• **OKAWARA, Chiharu**
  **Ushiku-shi**
  **Ibaraki 300-1201 (JP)**
• **YAMAUCHI, Koji**
  **Ushiku-shi**
  **Ibaraki 300-1201 (JP)**

(74) Representative: **Ter Meer Steinmeister & Partner Patentanwälte mbB**
  **Nymphenburger Straße 4**
  **80335 München (DE)**

(56) References cited:
**EP-A1- 1 941 993**    **JP-A- 2003 255 104**
**JP-A- 2009 132 060**    **US-A1- 2002 197 480**

## Description

Technical Field

The present invention relates to a gas barrier film, a method for producing the same, and a gas barrier laminate.

Background Art

A gas barrier plastic film including a plastic film as a base and an inorganic thin film such as a silicon oxide and the like formed on a surface thereof is widely used as a packaging material for articles which require blocking of various gases such as water vapor and oxygen, for example, a packaging material for preventing deterioration of foods, industrial goods, drugs, and the like.

The film packaging materials used for this purpose are desired to have a high gas barrier property against water vapor and oxygen in order to store foods and drugs for a long period of time, and many developments have been made.

In recent years, with rapid advances in electronics technology, a demand is expanding widely for electronic devices such as liquid crystal display panels, organic EL display panels, touch panels, electronic paper, solar cells, and the like. These electronic devices comprise generally glass substrates on which films having various functions are laminated and are supplied for various applications.

However, due to large specific gravity and low toughness of glass, there has been a problem that the devices become heavier in weight and are prone to get broken. Therefore, weight saving and toughening of the substrate are strongly desired, and plastic sheet and film are being employed in place of the glass substrate.

A plastic film used in these applications is required to have especially rigorous transparency (color, light transmittance, haze, and the like) and durability (the gas barrier property and transparency should not be damaged by a heat treatment, a high temperature and high humidity treatment, and the like) in addition to a very rigorous oxygen barrier property and a water vapor barrier property. Especially with regard to display-related applications, a plastic film is drawing attention as a protection for a display device element, a light emitting device element, and the like, and development of a gas barrier film which satisfies the required performances is strongly desired.

As described above, various studies are being conducted in order to make the gas barrier film exhibit a high gas barrier property, aiming at packaging applications. For example, as a means for improving the gas barrier property, there have been proposed a gas barrier film in which a mixture of a water-soluble polymer and inorganic particles is applied on an inorganic thin film (see, for example, Patent Document 1) and the like. However, these are proposals aimed at improving the gas barrier property or the stability and are not focusing on such aspects of improvement of transparency, suppression of appearance defect, and suppression of background reflection as well as glare.

As seen above, there have been few proposals made so far with an intention to improve transparency, together with the gas barrier performance, aiming at optical applications centered around displays and the like.

Citation List

Patent Document

[Patent Document 1] Japanese Patent Laid-Open Publication No. 2008-36863 EP 1 941 993 A1 is directed to a gas barrier multilayer film comprising a resin layer on a surface of an inorganic thin film which is formed on at least one side of a support film.

Summary of Invention

Problem to be solved by the Invention

A technology disclosed in Patent Document 1 includes an improvement of gas barrier property by means of a top coat layer (a resin layer) formed using an aqueous dispersion. However, when industrially implemented in the rotogravure coating, this generates fine cissing (appearance defect).

Furthermore, the technology disclosed in Patent Document 1 may pose a problem of appearance defect depending on the application (for example, displays and the like), although at a level that does not cause any problem in a packaging application. Further, because minute roughness and defective parts between the top coat and a vapor-deposited film cannot be fully complemented, glare due to reflection of outside light (background reflection) becomes pronounced.

The present invention was made under these circumstances and aims to provide a gas barrier film having excellent transparency with a low haze value and without occurrence of appearance defect, which is capable of suppressing background reflection and has an excellent water vapor barrier property; a method for producing the same; and a gas barrier laminate prepared using the gas barrier film.

Means for solving the Problem

The present inventors conducted diligent research in order to attain the above objects and, as a result, found that the objects can be accomplished by the following present invention. That is, the present invention is defined by the appended claims and is as follows.

A gas barrier film comprising a resin layer disposed on an inorganic layer formed on at least one surface of a substrate film, the resin layer containing polyvinyl alcohol and a silicon compound, wherein b* and a* values of the film measured based on JIS Z8722 are -1.0 to 1.0 and -1.0 to 1.0, respectively, wherein the inorganic layer comprises at least one layer of a PVD inorganic layer formed by physical vapor deposition (PVD) in the presence of introduced oxygen, wherein the inorganic layer is composed of silicon oxide, wherein the haze value is 0.1 to 4.0% as determinded according to JIS K7136:2000, the gas barrier film has a water vapor transmission rate of less than 0.5 g/m$^2$/24 h/atm at 60°C , 90% RH.

The present invention is also directed to a gas barrier laminate comprising the gas barrier film according to any of claims 1 to 3 laminated with a transparent film and/or a low shrinkage film via an adhesive layer or a pressure-sensitive adhesive layer interposed therebetween.

A further aspect of the invention is a protective sheet for a display, comprising the gas barrier laminate according to the invention.

A further aspect of the invention is a method for producing a gas barrier film according to claim 7.

Advantageous Effects of the Invention

According to the present invention, there can be provided a gas barrier film having excellent transparency with a low haze value without occurrence of appearance defect, which is capable of suppressing background reflection, and has an excellent water vapor barrier property; a method for producing the same; and a gas barrier laminate prepared by using the gas barrier film.

Embodiments for carrying out the Invention

[Gas barrier film and method for producing the same]

The gas barrier film of the present invention comprises a resin layer disposed on an inorganic layer formed on at least one surface of a substrate film, the resin layer containing polyvinyl alcohol and a silicon compound.

Furthermore, the gas barrier film of the present invention has b* and a* values measured based on JIS Z8722 of -1.0 to 1.0 and -1.0 to 1.0, respectively. Meanwhile, the b* and a* values denote those of an L*a*b* color coordinate system of JIS Z8729. The b* and a* values can be measured based on JIS Z8722.

The b* value is preferably -0.5 to 0.5, and more preferably 0 to 0.3. Also, the a* value is preferably -0.5 to 0.5, and more preferably -0.2 to 0.5.

Hereinafter, the substrate film, each layer and the like, and the method for producing a gas barrier film of the present invention will be described.

(Substrate film)

As a substrate film for the gas barrier film of the present invention, a thermoplastic polymer film is preferred. Any resin which can be used for usual optical materials can be used as a raw material thereof without particular limitation.

Specific examples thereof include: a polyolefin such as a homopolymer or a copolymer of ethylene, propylene, butene and the like; an amorphous polyolefin such as a cyclic polyolefin; a polyester such as polyethylene terephthalate, polyethylene-2,6-naphthalate and the like; a polyamide such as nylon 6, nylon 66, nylon 12, copolymer nylon and the like; a polyvinyl alcohol; an ethylene-vinyl acetate copolymer partial hydrolysate (EVOH) and the like; a polyimide; a polyetherimide; a polysulfone; a polyethersulfone; a polyetheretherketone; a polycarbonate; a polyvinyl butyral; a polyarylate; a fluororesin; an acrylate resin; a biodegradable resins and the like. Of these, a polyester, a polyamide, and a polyvinyl alcohol are preferred from the viewpoints of film strength, cost, and the like.

Further, unless the effects of the present invention are adversely affected, the above-mentioned substrate film may contain a known additive such as an antistatic agent, a light-blocking agent, a UV-absorber, a plasticizer, a lubricant, a filler, a colorant, a stabilizer, a lubricating agent, a crosslinking agent, an anti-blocking agent, an antioxidant and the like.

The thermoplastic polymer film used as the substrate film is produced by molding the above-mentioned raw materials. When employed as the substrate, the film may be unstretched or stretched. Further, the film may be single-layered or multi-layered.

The substrate film can be produced by a conventionally known method. For example, a resin raw material is melted by means of an extruder and extruded through a circular die or a T die, followed by quenching, whereby an unstretched film which is substantially amorphous and non-oriented can be produced. The unstretched film is stretched in a film flow direction (longitudinal direction) and/or in an orthogonal direction thereto (transverse direction) by a known method such as monoaxial stretching, tenter-based successive biaxial stretching, tenter-based simultaneous biaxial stretching, or tubular simultaneous biaxial stretching, whereby a film stretched in one or two axial directions can be produced.

The substrate film also includes a sheet-like film having a large thickness, has a thickness selected in the range of generally 5 to 500 $\mu$m, and preferably 10 to 200 $\mu$m depending on the applications, from the viewpoints of mechanical strength, flexibility, transparency, and the like. Especially, in an optical application centered around displays and the like, a thickness less than 50 $\mu$m is considered preferable from needs for weight saving and thinning of the entire protective sheet. Further, when the film is thin, creases and flexure become prone to occur during film lamination, making handling of the film difficult. Thus, a thickness of 12 $\mu$m or more is considered preferable.

Further, no particular limitation is imposed on the width and length of the film, and these dimensions may be appropriately selected depending on the applications.

If desired, the substrate film can be provided with a surface treatment on one or both of its surfaces by an oxidation method, a surface roughening method, and the like, in order to improve adhesiveness with a layer formed on the surface. The oxidation method includes, for example, a corona discharge treatment, a plasma treatment, a chromic acid treatment (wet type), a hot-air treatment, an ozone treatment, an ultraviolet irradiation treatment, and the like. Furthermore, the surface roughening method includes, for example, a sandblasting method, a solvent treating method, and the like. These surface treatment methods are suitably selected depending on the kind of the substrate film but, generally, the corona discharge treatment method is preferably used from the standpoint of effectiveness, operability, and the like.

In addition, in order to improve adhesiveness with an inorganic layer, the substrate film is preferably provided with an anchor coat layer.

As an anchor coating agent which forms this anchor coat layer, there may be used a solvent-based or a water-soluble agent such as polyester, urethane resin, acrylic resin, vinyl alcohol resin, ethylene-vinyl alcohol resin, vinyl modified resin, oxazoline group-containing resin, carbodiimide group-containing resin, epoxy group-containing resin, isocyanate group-containing resin, alkoxy group-containing resin, modified styrene resin, modified silicone resin, and the like, which may be used singly or in a combination of two or more kinds. Among them, from the standpoint of adhesiveness and hot water resistance, it is preferable to use at least one kind selected from a polyester, a urethane resin, an acrylic resin, an oxazoline group-containing resin, a carbodiimide group-containing resin, an epoxy group-containing resin, an isocyanate group-containing resin, and a copolymer of these. Further, preferable is a combination of one or more kinds of a polyester, a urethane resin, and an acrylic resin, with one or more kinds of an oxazoline group-containing resin, a carbodiimide group-containing resin, an epoxy group-containing resin, and an isocyanate group-containing resin.

The anchor coat layer preferably has a thickness of 0.005 to 5 $\mu$m, and more preferably 0.01 to 1 $\mu$m. When the thickness is 5 $\mu$m or less, the anchor coat layer has a good sliding property and rarely peels off from the substrate film due to its internal stress. Further, when the thickness is 0.005 $\mu$m or more, the anchor coat layer can maintain a uniform thickness and is preferable.

(Inorganic layer)

The inorganic layer pertaining to the present invention is composed of silicon oxide.

The inorganic layer preferably has a thickness (a total thickness when the inorganic layer has a multilayer structure) of 0.1 to 500 nm, and more preferably 0.5 to 40 nm. When the thickness is in the above-mentioned range, the inorganic thin film has sufficient gas barrier property and has excellent transparency without causing cracks and peeling-off.

In the present invention, the inorganic layer comprises at least one layer of a PVD inorganic layer formed by physical vapor deposition (PVD) in the presence of introduced oxygen. This can impart a high gas barrier property to the film. Furthermore, even though the inorganic layer may have a single layer structure comprising the PVD inorganic layer, in order to make the film exhibit a higher gas barrier property, it may comprise a multilayer structure, wherein a CVD inorganic layer formed by a chemical vapor deposition method or a PVD inorganic layer having the same or different composition is formed on the PVD inorganic layer. When usefulness is considered, preferable is a structure having the PVD inorganic layer and the CVD inorganic layer formed alternately (for example, a 3-layer structure of PVD layer/CVD layer/PVD layer, and the like).

Especially, by forming a CVD inorganic layer on a PVD inorganic layer, filling of defects and the like generated on the PVD inorganic layer may be performed, resulting in an improvement of the gas barrier property and adhesiveness between the layers.

Here, the carbon content of the CVD inorganic layer is, from the standpoint of gas barrier property, preferably less than 20 at.%, more preferably 10 at.% or less, and even more preferably 5 at.% or less. By adjusting the carbon content to such a value, surface energy of the inorganic layer becomes large, thus preventing reduction of adhesion between the inorganic layers. Therefore, resistance against bending and against peeling off of the barrier film becomes improved.

In addition, the carbon content of the CVD inorganic layer is preferably 0.5 at.% or more, more preferably 1 at.% or more, and even more preferably 2 at.% or more. Presence of a small amount of carbon contained in a middle layer enables efficient stress relaxation and decreases curling of the barrier film.

Here, the "at.%" denotes an atomic composition percentage (atomic %).

Meanwhile, when a PVD inorganic layer of a silicon oxide represented by $SiO_x$ (1.0<X≤2.0) is formed, the gas permeability decreases as the value of X becomes smaller, however, it sometimes occurs that the film itself turns yellowish and transparency thereof decreases. Therefore, in this case, if oxygen is introduced during the film forming and a degree of oxidation is raised, the transparency is improved but, on the other hand, the gas barrier property becomes deteriorated.

Pressure during formation of the PVD inorganic layer is, from the standpoint of the gas barrier property, evacuation capacity, and the degree of oxidation of the $SiO_x$ layer to be formed, in a range of $1 \times 10^{-7}$ to 1 Pa, preferably $1 \times 10^{-6}$ to $1 \times 10^{-1}$ Pa, and more preferably $1 \times 10^{-4}$ to $1 \times 10^{-2}$ Pa. When oxygen is introduced, its partial pressure relative to the total pressure is in a range of 20 to 80%. However, it has to be adjusted because, depending on the design of an apparatus, there may be a difference in the effect of oxygen during the film formation.

Furthermore, from the standpoint of productivity, the substrate film is preferably conveyed at a speed of 100 m/minute or more, and more preferably 200 m/minute or more. There is no particular upper limit, but, from the standpoint of stability of film conveyance, the speed is preferably 1000 m/minute or less.

Further, the formation of the CVD inorganic layer is preferably carried out in a reduced pressure environment of 10 Pa or less and at a substrate film conveyance speed of 100 m/minute or more. That is, regarding the pressure under which a thin film is formed by a chemical vapor deposition method (CVD), the film formation is preferably carried out under reduced pressure in order to form a dense and thin film and, from the standpoint of a film forming speed and a barrier property, the pressure is preferably 10 Pa or less, more preferably in a range of $1 \times 10^{-2}$ to 10 Pa, and even more preferably $1 \times 10^{-1}$ to 1 Pa.

This CVD inorganic layer, in order to improve its water resistance and durability, can also be provided with a crosslinking treatment by electron beam irradiation. Furthermore, from the standpoint of productivity, the substrate film is preferably conveyed at a speed of 100 m/minute or more, and more preferably 200 m/minute or more. There is no particular upper limit, but, from the standpoint of stability of film conveyance, the speed is preferably 1000 m/minute or less.

Of the CVD inorganic thin film, the thin film is preferably a thin film containing at least one kind selected from, for example, a metal, a metal oxide, and a metal nitride, and the metal is preferably such as silicon, aluminum, and diamond-like carbon (hereinafter, referred to as "DLC") in terms of the gas barrier property and adhesion property. Meanwhile, preferred examples of the metal oxide or metal nitride include oxides and nitrides of the above-mentioned metals and mixtures thereof in terms of gas barrier property and adhesion property. The CVD inorganic thin film is more preferably one which includes at least one kind selected from silicon oxide, silicon oxycarbide, silicon oxynitride, silicon oxycarbonitride, silicon nitride, and aluminum oxide from the above-mentioned viewpoint. Further, a metal oxide or metal nitride is preferably obtained by plasma decomposition of an organic compound.

As a raw material for formation of the plasma CVD thin film such as a silicon oxide film, a compound such as a silicon compound may be used in any state of a gas, liquid, or solid at normal temperature and pressure. If the compound is in a gas state, the compound can be fed into a discharge space without further treatments, but if the compound is in a liquid or solid state, the compound is gasified before use by means such as heating, bubbling, pressure reduction, or ultrasound irradiation. Further, the compound may be diluted with a solvent or the like before use, and the solvent which may be used is an organic solvent such as methanol, ethanol, or n-hexane or a mixed solvent thereof.

Examples of the above-mentioned silicon compound include silane, tetramethoxysilane, tetraethoxysilane, tetra-n-propoxysilane, tetraisopropoxysilane, tetra-n-butoxysilane, tetra-t-butoxysilane, dimethyldimethoxysilane, dimethyldiethoxysilane, diethyldimethoxysilane, diphenyldimethoxysilane, methyltriethoxysilane, ethyltrimethoxysilane, phenyltriethoxysilane, (3,3,3-trifluoropropyl)trimethoxysilane, hexamethyldisiloxane, bis(dimethylamino)dimethylsilane, bis(dimethylamino)methylvinylsilane, bis(ethylamino)dimethylsilane, N,O-bis(trimethylsilyl)acetamide, bis(trimethylsilyl)carbodiimide, diethylaminotrimethylsilane, dimethylaminodimethylsilane, hexamethyldisilazane, hexamethylcyclotrisilazane, heptamethyldisilazane, nonamethyltrisilazane, octamethylcyclotetrasilazane, tetrakisdimethylaminosilane, tetraisocyanatosilane, tetramethyldisilazane, tris(dimethylamino)silane, triethoxyfluorosilane, allyldimethylsilane, allyltrimethylsilane, benzyltrimethylsilane, bis(trimethylsilyl)acetylene, 1,4-bistrimethylsilyl-1,3-butadiyne, di-t-butylsilane, 1,3-disilabutane, bis(trimethylsilyl)methane, cyclopentadienyltrimethylsilane, phenyldimethylsilane, phenyltrimethylsilane, propargyltrimethylsilane, tetramethylsilane, trimethylsilylacetylene, 1-(trimethylsilyl)-1-propyne, tris(trimethylsilyl)methane, tris(trimethylsilyl)silane, vinyltrimethylsilane, hexamethyldisilane, octamethylcyclotetrasiloxane, tetramethylcyclotetrasiloxane, hexamethyldisiloxane, hexamethylcyclotetrasiloxane, and M-Silicate 51.

(Resin layer)

The resin layer pertaining to the present invention comprises polyvinyl alcohol and a silicon compound, and is formed on the aforementioned inorganic layer as a top coat layer. By forming the resin layer, yellowing or yellow-browning of the gas barrier film, caused by the inorganic layer, is suppressed, which enables the film to maintain a low haze value, good color, and transparency.

The content ratio of polyvinyl alcohol and the silicon compound in the resin layer is, from the viewpoint of the gas barrier property and transparency, preferably 1/6 to 1/2 in the mass ratio, and more preferably 1/5 to 1/3.

The resin layer can be formed, for example, by the following method.

First, an aqueous dispersion containing (a) polyvinyl alcohol and (c) a silicon compound is prepared. From the standpoint of the water vapor barrier property, high-speed gravure coating ability, and hot-water resistant adhesiveness, it is desirable that the dispersion further contains (b) an ethylene-unsaturated carboxylic acid copolymer and (d) a crosslinking agent. Subsequently, by coating the surface of the inorganic layer with the dispersion and drying, the resin layer can be formed as a top coat layer.

<(a) Polyvinyl alcohol>

Polyvinyl alcohol used as a constituent component of the resin layer can be produced by a heretofore known method and is usually obtained by saponifying a vinyl acetate polymer. The polyvinyl alcohol-based resin whose degree of saponification is 80% or more can be used. The degree of saponification is preferably 90% or more, more preferably 95% or more, and particularly preferably 98% or more.

An average degree of polymerization thereof is usually 200 to 3500 and is, from the standpoint of the gas barrier property, strength, and coatability, preferably 300 to 2000, and more preferably 500 to 1500. Further, as the polyvinyl alcohol, a product obtained by copolymerizing ethylene at a ratio of 40% or less can be used, and a product obtained by modification with carboxyl and the like can also be used. The degree of saponification and the average degree of polymerization can be measured according to JIS K6726 (Testing methods for polyvinyl alcohol).

An aqueous solution of polyvinyl alcohol can be prepared by, for example, forming a mixture by supplying a polyvinyl alcohol resin while stirring in water at normal temperature, which is then warmed and stirred at 80 to 95°C for 30 to 60 minutes.

<(b) Ethylene-unsaturated carboxylic acid copolymer>

An ethylene-unsaturated carboxylic acid copolymer, which is used as a constituent of the resin film, is a copolymer of ethylene with an unsaturated carboxylic acid such as acrylic acid, methacrylic acid, ethacrylic acid, fumaric acid, maleic acid, itaconic acid, monomethyl maleate, monoethyl maleate, maleic anhydride, or itaconic anhydride. Of these, a copolymer of ethylene with acrylic acid or methacrylic acid is preferred from the viewpoint of versatility. The ethylene-unsaturated carboxylic acid copolymer may contain any other monomer.

The content of the ethylene component in the ethylene-unsaturated carboxylic acid copolymer is, from the view points of versatility and flexibility, preferably 65 to 90 mass%, and more preferably 70 to 85 mass%. The ratio of the unsaturated carboxylic acid component is preferably 10 to 35 mass%, and more preferably 15 to 30 mass%.

Other monomer components which may be contained in the ethylene-unsaturated carboxylic acid copolymer include a vinyl ester such as vinyl acetate, vinyl propionate, and the like; and an unsaturated carboxylic acid ester such as methyl acrylate, ethyl acrylate, isopropyl acrylate, n-butyl acrylate, isobutyl acrylate, isooctyl acrylate, methyl methacrylate, isobutyl methacrylate, dimethyl maleate, diethyl maleate, and the like. These monomer components can be contained in a ratio of 0 to 50 mass%.

Such an ethylene-unsaturated carboxylic acid copolymer can be obtained by a heretofore known method such as, for example, radical polymerization under high temperature and high pressure.

In the present invention, from the viewpoint of gas barrier property, interlayer adhesion property, etc., the above-mentioned ethylene-unsaturated carboxylic acid copolymer preferably contains a neutralized substance thereof. The degree of neutralization of the neutralized substance is preferably 10 to 100%, more preferably 20 to 100%, and particularly preferably 40 to 100% from the viewpoint of gas barrier property.

The degree of neutralization can be calculated according to the following equation.

$$\text{Degree of neutralization} = (A/B) \times 100 \ (\%)$$

(A: Number of moles of a neutralized carboxyl group in 1 g of neutralized ethylene-unsaturated carboxylic acid copolymer, B: Number of moles of a carboxyl group in 1 g of ethylene-unsaturated carboxylic acid copolymer before neutralization)

For convenience, in the case of an aqueous dispersion, the degree of neutralization can be calculated by defining the above A as a number obtained by (number of metal ions in a solvent)×(valence of the metal ions) and defining the above B as the number of carboxyl groups in the ethylene-unsaturated carboxylic acid copolymer before neutralization.

From the viewpoint of gas barrier property, it is preferred to use the ethylene-unsaturated carboxylic acid copolymer in the form of an aqueous dispersion formed of the above-mentioned copolymer and a dispersion medium containing at least one selected from the followings: ammonia, sodium hydroxide, potassium hydroxide, lithium hydroxide, and the like. An aqueous dispersion containing the above-mentioned dispersion medium is preferably used in such a manner that the degree of neutralization becomes equal to the above-mentioned value, with respect to the total number of moles of the carboxyl group contained in the ethylene-unsaturated carboxylic acid copolymer.

To produce an aqueous dispersion from the ethylene-unsaturated carboxylic acid copolymer and the dispersion medium, for example, a prescribed amount of water and the both raw materials are fed into a vessel provided with a stirrer and the resultant mixture is stirred at a temperature of 90 to 150°C for about 10 minutes to 2 hours. The aqueous dispersion thus obtained has excellent stability and, even after storage for a long period of time, the particles size and viscosity thereof do not change too much.

The ethylene-unsaturated carboxylic acid copolymer may further contain a divalent or trivalent metal. Such a divalent or trivalent metal can be introduced into the copolymer by adding it as an oxide together with the dispersion medium during the preparation of the aqueous dispersion. Further, the metal may be introduced into the copolymer by adding it in a form of a metal carbonate or a metal sulfate instead of the oxide. The metal can be introduced in a ratio of 0 to 60 mol% relative to the number of moles of carboxyl groups of the ethylene-unsaturated carboxylic acid copolymer.

In the present invention, one kind may be used or two or more kinds of the above-mentioned ethylene-unsaturated carboxylic acid copolymer, may also be used in combination.

<(c) Silicon compound>

As the silicon compound used as a constituent component of the resin layer, preferable are silicon oxides which include, for example, silicon dioxide particles, silicon oxide particles represented by $SiO_x$, a silica sol, and the like. These may be used singly or in combination of two or more kinds.

In addition, X in $SiO_x$ is preferably larger than 1.0 but not larger than 2.0.

Furthermore, an average particle size thereof is, from the standpoint of hot-water resistance and cohesive failure resistance, preferably 0.5 nm to 2 μm, more preferably 0.5 nm to 200 nm, even more preferably 1 nm to 200 nm, and especially preferably 1 nm to 100 nm. The average particle size of the silicon compound can be measured, for example, by a nitrogen gas adsorption method (BET), an electron microscopic observation, a small-angle X-ray scattering analysis, a dynamic light scattering method, and the like. However, in the present invention, values measured by the dynamic light scattering method will be used.

A preparation method of the silicon compound particles is not particularly limited but can be prepared, for example, by a method described in International Publication No. WO 95/17349 from page 2, line 16 to page 10, line 26 or Japanese Patent Laid-Open Publication No. H6-16414 from paragraph [0012] to [0031], specifically by a method of hydrolyzing an alkoxysilane followed by aging; a method of dissolving water glass, exchanging ions, and concentrating; and the like. In the former preparation method, calculation of a ratio of functional groups can be performed by a method described in the above International Patent Laid-Open Publication from page 15, line 19 to page 16, line 8 and, in the latter preparation method, silanol groups can be estimated to be 100 mol%.

Generally, regarding the use of an alkoxysilane, a coating liquid obtained by mixing athealkoxysilane or a hydrolysate thereof with a resin is known to be applied on a film having an inorganic layer. However, the alkoxysilane and the hydrolysate thereof have a very strong cohesive stress and they rather damage the inorganic layer and deteriorate the gas barrier property. This tendency is pronounced especially under a hot water. The mutual interaction of the coating layer with the resin component and cohesive force can be adjusted, by using a silica product formed into particles obtained by performing hydrolysis-condensation of the alkoxysilane and aging to achieve the partial cross-linking reaction to a full extent, and preferably using silica containing silanol groups.

<(d) Crosslinking agent>

The crosslinking agent used as a constituent component of the resin layer is not particularly limited as long as it is a compound which reacts with reactive functional groups of polyvinyl alcohol, the component (a), and an ethylene-unsaturated carboxylic acid copolymer, the component (b), and can crosslink them. There may be mentioned many compounds having various groups corresponding to the above-mentioned reactive functional groups.

The reactive functional groups of the polyvinyl alcohol and the ethylene-unsaturated carboxylic acid copolymer include not only a carboxyl group and a salt-type carboxyl group but also other various functional groups having active hydrogen introduced by other components which are further copolymerized as desired.

The crosslinkable functional group of the crosslinking agent includes groups which can react with the functional groups of the polyvinyl alcohol and the ethylene-unsaturated carboxylic acid copolymer, for example, a carbodiimide group, an oxazoline group, an isocyanate group, an epoxy group, a methylol group, an aldehyde group, an acid anhydride group, an aziridinyl group, and the like. From the standpoint of stability of a mixed aqueous dispersion, the carbodiimide group, the oxazoline group, the isocyanate group, or the epoxy group is preferable. Of these functional groups, one kind or two or more kinds may be introduced in one molecule and, from the standpoint of crosslinkability, it is preferable that two or more of the crosslinkable functional groups are introduced in one molecule.

As a water-soluble polymer having two or more oxazoline groups, there can be used one formed by polymerizing an oxazoline group-containing monomer and an ethylenic unsaturated monomer which is used as necessary.

Here, the oxazoline group-containing monomer includes, for example, 2-vinyloxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline, 2-isopropenyl-5-ethyl-2-oxazoline, and the like. These may be used singly or in combination of two or more kinds but, among others, 2-isopropenyl-2-oxazoline is preferable because it is easy to obtain industrially.

As the crosslinking agent, preferable is a water-soluble polymer having the above-mentioned functional groups. Especially, more preferable is a water-soluble polymer having two or more oxazoline groups, carbodiimide groups, epoxy groups, isocyanate groups, and the like, which has excellent reactivity with polyvinyl alcohol and the carboxyl group or the salt-type carboxyl group of the ethylene-unsaturated carboxylic acid copolymer and provides a crosslinked resin film having desired performance.

Further, from the standpoint of a gas barrier property and printing resistance, the resin layer preferably contains polyvinyl alcohol in an amount of 5 to 70 mass%, and more preferably 10 to 30 mass%. Furthermore, from the standpoint of the gas barrier property, high-speed gravure coating ability, and hot water-resistant adhesiveness, the resin layer preferably contains the ethylene-unsaturated carboxylic acid copolymer in an amount of 10 to 70 mass%, and more preferably 20 to 60 mass%. From the standpoint of high-speed gravure coating ability, printing resistance, and hot water-resistant adhesiveness, the resin layer preferably contains silicon compound particles in an amount of 20 to 70 mass%, and more preferably 30 to 60 mass%. Additionally, from the standpoint of hot water resistance, the resin layer preferably contains the crosslinking agent in an amount of 2 to 30 mass%, and more preferably 3 to 10 mass%.

The aqueous dispersion used to form the resin layer preferably contains each component of (a) polyvinyl alcohol, (b) an ethylene-unsaturated carboxylic acid copolymer, (c) silicon compound particles, and (d) a crosslinking agent in an amount which makes the content thereof in the resin layer equal to the value mentioned above.

In the aqueous dispersion, there may be blended various heretofore known additives as necessary. Examples of the additive include: polyalcohol such as glycerin, ethylene glycol, polyethylene glycol, and polypropylene glycol; a silane coupling agent; lower alcohol such as methanol, ethanol, n-propanol, and isopropanol; ether such as ethylene glycol monomethyl ether, propylene glycol monomethyl ether, propylene glycol diethyl ether, diethylene glycol monoethyl ether, and propylene glycol monoethyl ether; ester such as propylene glycol monoacetate and ethylene glycol monoacetate; an antioxidant; a weathering stabilizer; a UV absorber; an antistatic agent; a pigment; a dye; an antibacterial agent; a lubricant; an inorganic filler; an anti-blocking agent; and an adhesive agent.

Further, the aqueous dispersion may be used mixed with an aqueous dispersion of other resin. Such an aqueous resin dispersion includes one kind or two or more kinds selected from aqueous dispersions of a polyvinyl acetate, an ethylene-vinyl acetate copolymer, a polyvinyl chloride, a polyvinylidene chloride, an acrylic resin, an acrylamide resin, a methacrylamide resin, an acrylonitrile resin, a styrene-acrylic acid copolymer, a polyurethane, a styrenemaleic acid copolymer, a styrene-butadiene copolymer, a high-impact polystyrene resin, a butadiene resin, a polyester, an acrylonitrile-butadiene copolymer, a polyethylene, an oxidized polyethylene, a propylene-ethylene copolymer, a maleic acid-grafted propylene-ethylene copolymer, a chlorinated polyethylene, a chlorinated polypropylene, EPDM, a phenolic resin, a silicone resin, and the like.

A method for preparing an aqueous dispersion of the present invention is not particularly limited. However, the dispersion can be prepared, for example, by a method of dissolving each polymer in water and adding thereto silicon compound particles or an aqueous solution thereof, and a crosslinking agent composed of a water-soluble polymer containing crosslinkable functional groups or an aqueous solution thereof; a method of mixing an aqueous solution of each resin, silicon compound particles or an aqueous solution thereof, and a crosslinking agent composed of a water-soluble polymer containing crosslinkable functional groups or an aqueous solution thereof; a method of polymerizing each monomer in an aqueous polyvinyl alcohol solution and subsequently adding thereto silicon compound particles or an aqueous solution thereof, and a crosslinking agent composed of a water-soluble polymer containing crosslinkable functional groups or an aqueous solution thereof; a method of polymerizing each monomer in an aqueous polyvinyl alcohol solution, followed by neutralization with an alkali and adding thereto silicon compound particles or an aqueous solution thereof, and a crosslinking agent composed of a water-soluble polymer containing crosslinkable functional groups or an aqueous solution thereof; and the like. In the above-mentioned cases, the mixtures may be prepared using solvents other than water, such as alcohols and the like.

With regard to the coating liquid used in forming the resin layer, an aqueous coating liquid is preferably selected from the standpoint of an environmental load and effects on worker health due to generation of VOCs (volatile organic compounds). When coating the inorganic surface with the aqueous dispersion, heretofore known coating methods may be applied. For example, any of methods such as reverse roll coater, gravure coater, rod coater, air doctor coater, and a coating method using a spray can be employed. Further, coating may also be carried out by dipping a substrate film into the aqueous dispersion after forming an inorganic layer on the substrate film. In the present invention, good coating properties can be obtained also using high-speed gravure coating. After the coating, water can be evaporated using a known drying method such as drying by heating at a temperature of about 80 to 200°C, e.g., hot-air drying or heat roll drying, or infrared drying. Herewith, there is obtained a gas barrier film having a uniformly coated resin layer.

In the gas barrier film of the present invention, the thickness of the resin layer is not particularly limited and is usually 0.05 to 20 $\mu$m. However, from the standpoint of printing gradation, cost, and the like, the thickness is preferably 0.05 to 10 $\mu$m, and more preferably 0.1 to 2 $\mu$m. This resin layer may be subjected to a crosslinking treatment by electron beam irradiation in order to improve water resistance and durability thereof.

(Annealing treatment)

As mentioned previously, the gas barrier film of the present invention can be obtained by disposing a resin layer as a top coat layer on an inorganic layer formed on at least one surface of a substrate film and applying, for example, an annealing treatment thereto. This annealing treatment can be performed by heat-treating a film having an inorganic layer (a vapor-deposited film) provided with a resin layer disposed on its surface.

Application of the annealing treatment makes it possible to complement minute surface roughness, and defective parts between the resin layer and the inorganic layer, and can reduce a haze value of the film.

In a display application, too low a haze value leads to glare of an image and too high a haze value leads to whitish turbidity and lowering of image definition and visibility. Therefore, from the standpoint of optical design, the haze value must be set rigorously. The haze value (JIS K7136:2000) is 0.1 to 4.0%, and preferably 0.5 to 3.0%.

Additionally, when the haze value is large, a color tone becomes clearer. Thus, when an inorganic layer containing $SiO_x$ is present, yellowish-brown color becomes pronounced and interferes with transparency. Furthermore, film-forming techniques including vacuum deposition and the like sometimes further reduce surface roughness of the base substrate. Thus, it is difficult to attain a low haze value of the barrier film.

Therefore, according to the present invention, disposition of a resin layer suppresses refraction and scattering of light due to the surface roughness, resulting in suppression of onset of a surface haze. Also, an annealing treatment pertaining to the present invention suppresses refraction and scattering of light due to the roughness present on the interface between the resin layer and the inorganic layer containing $SiO_x$, resulting in suppression of the onset of an internal haze.

The annealing treatment temperature depends on an organic material such as a substrate film and the like, which are to be used. The annealing treatment temperature is preferably 60°C or more, and more preferably 70°C or more for the annealing treatment effect to be exhibited.

From the viewpoint of preventing deterioration in the gas barrier property due to thermal decomposition of components constituting the gas barrier film, the upper limit of the annealing treatment temperature is preferably equal or lower than the melting point of the material of the substrate film, and more preferably equal or lower than the glass transition temperature of the material of the substrate film.

The annealing treatment time depends on the treatment temperature. The higher the treatment temperature is, preferably the shorter the treatment time is.
Specifically, the annealing treatment temperature is 60°C to 150°C, wherein the annealing treatment time is between 3 days to 6 months for 60°C, 3 hours to 10 days for 80°C, 1 hour to 1 day for 120°C, and 3 minutes to 60 minutes for 150°C.

As a means for performing the annealing treatment, there may be employed, for example: a method involving storing the film in an oven or a thermostat chamber whose temperature is set at a required temperature; a method involving applying hot blow to the film; a method involving heating the film with an infrared heater; a method involving irradiating the film with light using a lamp; a method involving directly providing heat to the film by bringing the film into contact with a hot roll or a hot plate; or a method involving irradiating the film with a microwave. Further, the film may be subjected to an annealing treatment after being cut to a dimension at which the handling thereof is facilitated, or a film roll may be subjected to an annealing treatment as it is.

The annealing treatment is preferably performed at a timing when the resin layer is disposed on the inorganic layer and may be performed not only once but also a plurality of times. When laminating the film with other film via an adhesive or a pressure-sensitive adhesive interposed therebetween, a heat treatment for aging the adhesive or the pressure-sensitive adhesive may be applied as an annealing method. That is, as long as required time and temperature can be assured, an annealing treatment may also be performed by incorporating a heating device as a part of a film production equipment including a coater, a slitter, a laminator, and the like, and performing heating during the film production process.

As described above, the gas barrier film of the present invention is produced by forming an inorganic layer (at least one layer formed by an oxygen-introduced physical vapor deposition method) on at least one surface of a substrate film, subsequently forming, on the inorganic layer, a resin layer containing polyvinyl alcohol and a silicon compound, and thereafter applying an annealing treatment,

The thus produced gas barrier film has a water vapor transmission rate of less than 0.5 $g/m^2/24$ h/atm at 60°C, 90% RH (relative humidity). Especially, the water vapor transmission rate at 60°C, 90% RH (relative humidity) is more preferably less than 0.3 $g/m^2/24$ h/atm.

[Gas barrier laminate]

The gas barrier film of the present invention can be used as a gas barrier laminate prepared by laminating the gas barrier film with at least one layer of a transparent film and/or a low shrinkage film via an adhesive layer or a pressure-sensitive adhesive layer interposed therebetween.

The transparent film is preferably a thermoplastic polymer film and any resin can be used without particular limitation as long as it can be used as an optical material. Specific examples thereof include: a polyolefin such as a homopolymer or copolymer of ethylene, propylene, and butene; an amorphous polyolefin such as a cyclic polyolefin; a polyester such as polyethylene terephthalate and polyethylene-2,6-naphthalate; a polyamide such as nylon 6, nylon 66, nylon 12, and copolymer nylon; a polyvinyl alcohol; an ethylene-vinyl acetate copolymer partial hydrolysate (EVOH); a polyimide; a polyetherimide; a polysulfone; a polyethersulfone; a polyetheretherketone; a polycarbonate; a polyvinyl butyral; a polyarylate; a fluororesin; an acrylate resin; and a biodegradable resin. From the standpoint of film strength, cost, and the like, preferable are a polyester, a polyamide, and a polyvinyl alcohol.

Further, unless the effects of the present invention are adversely affected, the above-mentioned transparent film may contain known additives such as an antistatic agent, a light-blocking agent, a UV-absorber, a plasticizer, a lubricant, a filler, a colorant, a stabilizer, a lubricating agent, a crosslinking agent, an anti-blocking agent, and an antioxidant. Further, by providing the transparent film with a function such as, for example, a heat-sealing property, an ultraviolet absorbing property, and the like, the gas barrier laminate can be used as a functional gas barrier laminate.

As for the shrinkage, it is important for preventing deterioration of the gas barrier property in terms of stress loading on the inorganic film and residual strain at an adhesion interface of the laminate due to dimensional change caused by the heat treatment of the laminate. Thus, as the low shrinkage film, preferable is one having a shrinkage rate of 3% or less after a treatment at 150°C for 30 minutes.

The gas barrier laminate can be obtained by using the gas barrier film of the present invention as a base material and laminating this with a transparent film and/or a low shrinkage film via a laminating adhesive layer or a pressure-sensitive adhesive layer interposed therebetween.

An adhesive which forms the laminating adhesive layer is not particularly limited, but there may be used, for example, a polyvinyl acetate-based adhesive; a polyacrylic acid ester-based adhesive composed of a homopolymer of ethyl, butyl, or 2-ethylhexyl acrylate or a copolymer of these with methyl methacrylate, acrylonitrile, styrene, and the like; a cyanoacrylate-based adhesive; an ethylene copolymer-based adhesive composed of a copolymer of ethylene with a monomer such as vinyl acetate, ethyl acrylate, acrylic acid, methacrylic acid, and the like; a cellulose-based adhesive; a polyester-based adhesive; a polyamide-based adhesive; a polyimide-based adhesive; an amino resin-based adhesive composed of a urea resin, a melamine resin, or the like; a phenol resin-based adhesive; an epoxy resin-based adhesive; a polyurethane-based adhesive; a reactive (meth)acrylic adhesive; a rubber-based adhesive composed of a chloroprene rubber, a nitrile rubber, a styrene-butadiene rubber, or the like; a silicone-based adhesive; an inorganic adhesive composed of an alkali metal silicate, low-melting-point glass, or the like. The above-mentioned adhesives may be in any form of an aqueous type, a solvent type, an emulsion type, a dispersion type, and the like.

Further, it is necessary for these adhesives that adhesive strength is maintained even after prolonged use, so that delamination and the like due to degradation do not occur, and further that the adhesive does not yellow. Moreover, suitable is one whose adhesive layer after curing shows little structural change under a heat lamination condition or in an accelerated test. In this respect, in an adhesive which is cured by a crosslinking reaction, it is preferable that the crosslinking proceeds sufficiently by coating and cuing of the adhesive, and that the amount of uncrosslinked functional group is small.

Based on an idea of using main agents having different molecular weights and a curing agent in order to obtain sufficient crosslink density and suppress the number of residual functional groups, for example, a method of using a mixture of a plurality of polyols as the main agents may also be employed. The main agent of the adhesive specifically includes a polycarbonate polyol, a polyether polyol, a polyacrylic polyol, a polyurethane polyol, a polyester polyol, and the like. Especially, from the standpoint of improving thermal stability, hydrolysis resistance, and the like, more preferable are the polycarbonate polyol, the polyether polyol, and the polyurethane polyol.

As the curing agent used for the adhesive, preferable is a diisocyanate, which includes, for example, an aliphatic one such as hexamethylene diisocyanate (HDI) and the like; an aromatic one such as xylylene diisocyanate (XDI), diphenylmethane diisocyanate (MDI), and the like; and an alicyclic one such as isophorone diisocyanate (IPDI), dicyclohexylmethane diisocyanate (H12MDI), and the like.

On the other hand, a pressure-sensitive adhesive which forms the pressure-sensitive layer used for laminate includes, for example, a natural rubber-based one, a synthetic rubber-based one, an acrylic resin-based one, a polyvinyl ether-based one, an urethane resin-based one, a silicone resin-based one, and the like.

Specific examples of the synthetic rubber-based rubber component include a styrene-butadiene rubber, a polyisobutylene rubber, an isobutylene-isoprene rubber, an isoprene rubber, a styrene-isoprene block copolymer, a styrene-butadiene block copolymer, a styrene-ethylene-butylene block copolymer, and the like.

Specific examples of acrylic resin-based resin component include a homopolymer, a copolymer or the like of acrylic acid, methyl acrylate, ethyl acrylate, propyl acrylate, butyl acrylate, 2-ethylhexyl acrylate, ethyl methacrylate, butyl methacrylate, acrylonitrile, and the like.

Specific examples of polyvinyl ether resin-based resin component include polyvinyl ether, polyvinyl isobutyl ether, and the like.

Specific examples of silicone resin-based resin component include dimethyl polysiloxane and the like.

Furthermore, it is preferable that, on at least one surface of the gas barrier film or the gas barrier laminate of the present invention, at least one layer selected from a glare-proof layer (an anti-glare layer), a low-reflection layer (an anti-reflection layer), and a glare-proof and low-reflection layer is formed as a functional layer.

The glare-proof layer is not particularly limited as long as it does not interfere with the effects of the present invention, and is transparent and possesses an anti-glare property, and preferable is a layer having an uneven structure on the surface. In the present invention, by forming a glare-proof layer, glaring and flickering on the display unit and the like of an electronic device can be suppressed and visibility can be improved.

The glare-proof layer having an uneven structure on the surface includes, for example, a layer having an uneven structure formed by phase separation of a plurality of resin components (or precursors thereof) (a glare-proof layer using phase separation); a layer having an uneven structure formed by blending particles in a resin component (or a precursor thereof) (a glare-proof layer having blended particles); a layer having an uneven structure formed by using a mold; and the like. Among these, from the standpoint of easy realization of a high glare-proof property, preferable is the layer having blended particles in a resin.

The method of forming a glare-proof layer is not particularly limited but is obtained by coating and curing a dispersion of particles in a heat-curable resin or a photocurable resin including an acrylic resin, a silicone-based resin, a melamine-based resin, a urethane-based resin, an alkyd-based resin, a fluorine-based resin, and the like.

As the particles, there can be used inorganic particles of silicon dioxide, titanium oxide, aluminum oxide, zinc oxide, tin oxide, calcium carbonate, barium sulfate, talc, kaolin, calcium sulfate, and the like; and organic particles of a poly(meth)acrylate-based resin, a silicone-based resin, a polystyrene-based resin, a polycarbonate-based resin, an acryl-styrene-based resin, a melamine-based resin, a polyolefin-based resin, a polyester-based resin, a polyamide-based resin, a polyimide-based resin, a polyfluoroethylene-based resin, and the like.

Further, as a structure of the low-reflection layer, there are known various kinds including a single-layered one, a multi-layered one, and the like.

As the multilayered structure, general is one having a structure where high refractive index layers and low refractive index layers are laminated alternately. There may be mentioned one having a high refractive index layer/a low refractive index layer laminated in this order from a side of the gas barrier film or the gas barrier laminate of the present invention; one having three layers having different refractive indices laminated in the order of a middle refractive index layer (a layer having a higher refractive index than the gas barrier film, the gas barrier laminate of the present invention, or a resin layer which constitutes these, and having a lower refractive index than a high refractive index layer)/a high refractive index layer/a low refractive index layer, and the like; and, further, one having many low-reflection layers laminated. Above all, from the standpoint of durability, optical characteristics, cost, and productivity, it is preferable to form a low-reflection layer by coating in the order of a high refractive index layer/an intermediate refractive index layer/a low refractive index layer.

A method for forming the high refractive index layer, the low refractive index layer, and the like is not particularly limited, but these are obtained by vacuum coating such as a physical vapor deposition (PVD) method and a chemical vapor deposition (CVD) method, sol-gel coating, precise wet coating, extrusion coating, and the like. Specific examples include a thin film of silicon oxide, silicon nitride, silicon oxynitride, titanium oxide, germanium oxide, hafnium oxide, zirconium oxide, cerium oxide, or a combination of these; and a porous thin film obtained by binding fine particles of a fluorine-based transparent polymer resin, a silicone-based resin, silica, and the like by using a suitable binder.

Furthermore, there may be disposed a glare-proof and low-reflection layer having a low-reflection function and a glare-proof function at the same time. This is obtained by forming a low-reflection layer on a glare-proof layer. In this case, when the glare-proof layer is a film having a high refractive index, a relatively high anti-reflection property can be provided even when the low-reflection layer is composed of a single layer.

The gas barrier laminate of the present invention is preferably applied to a display-protective sheet for a liquid crystal display, a solar cell, an electromagnetic shielding material, a touch panel, a substrate for EL, a color filter and the like.

Examples

Hereinafter, the present invention is specifically described by way of examples.

Methods for measuring characteristics of a gas barrier film and a gas barrier laminate obtained in each Example are shown in the following.

<Measurement of water vapor transmission>

In accordance with the conditions stipulated in JIS Z0222 "Water vapor transmission test for moisture-proof packaging container" and JIS Z0208 "Water vapor transmission test for moisture-proof packaging material," water vapor transmission was determined through the following procedure.

In each analysis, a four-side-sealed bag was fabricated from two gas barrier laminates each having a water vapor permeation area of 10.0 cm×10.0 cm, and about 20 g of calcium chloride anhydride serving as a hygroscopic agent was placed in the bag. The bag was placed in a thermo-hygrostat at a temperature of 40°C and a relative humidity of 90% or at a temperature of 60°C and a relative humidity of 90% , and weighed (precision: 0.1 mg) for 14 days at intervals of 48 hours or longer. The water vapor transmission was calculated from the following equation. (In Table 2 which shows the results of the evaluations, the water vapor transmission value at the third day is taken.)

Further, when the water vapor transmission rate, calculated by the following equation from measurements performed for 14 days at a temperature of 60°C and relative humidity of 90%, did not become nearly constant but tended to increase with elapsed time, the sample was considered as having no water vapor barrier stability and was evaluated as "poor." In measurements performed for 14 days, a sample, which showed a nearly constant water vapor transmission rate calculated by the following equation, was considered as having water vapor barrier stability and was evaluated as "good."

$$\text{Water vapor transmission rate } (\text{g/m}^2/24 \text{ h}) = (m/s)/t,$$

where parameters are as follows:

m: increment of mass (g) between the last two measurements in the test;
s: water vapor transmission area ($m^2$); and
t: duration (h)/24 (h) between the last two measurements in the test.

<Haze value>

The gas barrier film was subjected to a measurement of a haze value (%) by using a haze meter ("NDH 2000" manufactured by Nippon Denshoku Industries Co., Ltd.) with a light source set at D65.

<Colorimetry>

The gas barrier film was subjected to a measurement of L*, a*, and b* values of an L*a*b* color system by using a spectrophotometer ("SD-6000" manufactured by Nippon Denshoku Industries Co., Ltd.) with a light source and a viewing angle set at D65 and 2°, respectively. In Table 1, only the a* and b* values are shown.

<Background reflection>

Glare due to reflection of outside light and a degree of transparency were visually checked.

Placing a film with a coated or vapor-deposited surface thereof facing the observer, reflection of a white fluorescent lamp shed askew on the surface was observed. When glare was present and the reflection of the white fluorescent lamp appeared colored, the background reflection property was judged as "poor." When glare was absent and the reflection of the white fluorescent lamp did not appear colored, the background reflection property was judged as "good." When slight glare was present or the reflection appeared slightly colored, the background reflection property was judged as "fair."

<Film thickness of PVD inorganic layer formed by physical vapor deposition (PVD)>

A measurement of a thickness of an inorganic layer was performed by using a fluorescent X-ray method. This is a method which utilizes a phenomenon in which atoms irradiated by X-rays emit fluorescent X-rays specific to the atoms. By measuring intensity of the emitted fluorescent X-rays, the number (amount) of atoms can be known. Specifically, thin films of two known thicknesses are formed on a film, the intensity of specific fluorescent X-rays emitted are measured for each of these, and, from this information, a calibration curve is prepared. The intensity of fluorescent X-rays is similarly measured for a measurement sample and, from the calibration curve, the thickness thereof was obtained.

<Film thickness of CVD inorganic layer formed by chemical vapor deposition (CVD)>

A specimen was prepared by a method of ultrathin sectioning of a film sample embedded in an epoxy resin and a film thickness was measured by cross-section TEM ("JEM-1200 EXII") manufactured by JEOL Ltd., under the condition of an accelerating voltage of 120 kV.

<Carbon content of CVD inorganic layer>

Binding energies were measured by XPS (X-ray photoelectron spectroscopy) using an XPS analyzer "K-Alpha" manufactured by Thermo Fisher Scientific Inc. An elemental composition (at. %) was calculated by conversion from areas of peaks corresponding to Si2p, C1s, N1s, O1s, and the like.

Furthermore, the carbon content of a CVD inorganic layer was evaluated by reading values of a portion of an XPS chart corresponding to the CVD inorganic layer.

<Evaluation of appearance>

Coating defects of a resin layer disposed on an inorganic layer were checked visually.

After setting a film roll on an unwinding inspection machine, an arbitrary length of the film was unwound, and visual inspection of the film was carried out for a length of 1 m over the whole width. The film was illuminated with a white fluorescent lamp from a side of a coated surface or a vapor-deposited surface, and visual inspection was performed in all directions to check whether or not portions of abnormal appearance were present.

Additionally, a resin layer, disposed on an inorganic layer, having no or little defects in appearance was evaluated as "good"; one having clearly visually observable abnormal portions (appearance defects due to cissing on the resin layer) was evaluated as "poor,"; and one having clearly observable abnormal portions (appearance defects due to cissing on the resin layer) only on both coating edges was evaluated as "fair."

[Preparation Example 1] Preparation of an anchor coating agent

An anchor coating agent was prepared by blending an isocyanate compound ("Coronate L" produced by Nippon Polyurethane Industry Co., Ltd.) and a saturated polyester ("Vyron 300" produced by Toyobo Co., Ltd.; number average molecular weight, 23,000) in a 1:1 mass ratio.

[Preparation Example 2] Preparation of a top coating agent

A top coating agent composed of an aqueous dispersion was prepared by blending and mixing (a), (b), (c) and (d), which were prepared as described below, in such a way that their mass ratio in terms of solid content became 10:30:30:30.

(a) Polyvinyl alcohol (PVA, "Gohsenol NM-14" produced by Nippon Synthetic Chemical Industry Co., Ltd., degree of saponification: 99 mol% or more, degree of polymerization: 1400) was added to ion-exchanged water under stirring and dissolved at 95°C for 60 minutes to prepare an aqueous solution (a) of PVA having a solid concentration of 10%.

(b) An ethylene-methacrylic acid copolymer (EMAA) (methacrylic acid: 20 wt%, MFR: 300 g/10 minutes), ammonia, and ion-exchanged water were mixed under stirring at 95°C for 2 hours to prepare an aqueous solution (b) with a degree of neutralization of 60% and a solid content of 20%.

(c) An aqueous solution of sodium silicate was prepared in accordance with descriptions given in Japanese Patent Laid-Open Publication No. H6-16414 by dissolving sodium liquid glass, JIS No. 3, in an aqueous sodium nitrate solution. Subsequently, this solution was passed in sequence through a hydrogen-type cation-exchange resin column, a hydroxide-type anion-exchange resin column, and again a hydrogen-type cation-exchange resin column, and thereafter an aqueous sodium hydroxide solution was added thereto to obtain an aqueous silicic acid solution. Then, a 20% amount of the aqueous silicic acid solution was distilled under reduced pressure to remove evaporated water. And, at the same time, under continuous and gradual feeding of the residual aqueous silicic acid solution, distillation under reduced pressure was continuously carried out to prepare a colloidal silica sol. The colloidal silica sol was passed in sequence through a hydrogen-type cation-exchange resin column, a hydroxide-type anion-exchange resin column, and again a hydrogen-type cation-exchange resin column, and immediately thereafter special grade aqueous ammonia was added to prepare an aqueous silica sol (c) of pH 9 with an average particle size of 4 nm and a concentration of various metal oxides of 500 ppm.

(d) To a flask equipped with a stirrer, a reflux condenser, a nitrogen inlet tube, a thermometer, and a dropping funnel were charged 179 mass parts of deionized water and 1 mass part of 2,2'-azobis(2-amidinopropane) dihydrochloride which is a polymerization initiator. The mixture was heated to 60°C under a gentle flow of nitrogen gas and thereto was dropwise added over a 1 hour period a monomer mixture prepared in advance composed of 2 mass parts of ethyl acrylate, 2 mass parts of methyl methacrylate, and 16 mass parts of 2-isopropenyl-2-oxazoline. Thereafter, a reaction was carried out at 60°C for 10 hours under a nitrogen flow and after the reaction, the reaction mixture was cooled to prepare an aqueous solution (d) of a 2-oxazoline group-containing resin having a solid concentration of 10 wt%.

[Example 1]

Using a biaxially drawn polyethylene terephthalate film ("G332#19" produced by Mitsubishi Plastics, Inc.) of a thickness of 19 $\mu$m as a substrate film, an anchor coating agent obtained in Preparation Example 1 was applied on a corona-treated surface thereof and dried to form an anchor coat layer of a thickness of 100 nm.

Subsequently, by using a vacuum deposition equipment, SiO (purity of 99.9% or more) was evaporated by a heating system, oxygen was introduced to an oxygen partial pressure of $3.5 \times 10^{-3}$ Pa, and a PVD inorganic layer of $SiO_x$ of a thickness of 40 nm was formed on the anchor coat layer under a vacuum of $5 \times 10^{-3}$ Pa.

Subsequently, HMDSN (hexamethyldisilazane), nitrogen and Ar gas were fed at a molar ratio of 1:7:7 into the same vacuum deposition device without bringing the pressure back to an atmospheric pressure, and a plasma was generated under a vacuum of 0.4 Pa to form a plasma CVD film (SiOCN, siliconoxycarbonitride) (thickness: 1 nm) on the PVD inorganic thin film surface. When forming the CVD inorganic layer, a conveyance speed of the substrate film was set at 250 m/minute.

Subsequently, oxygen was fed again into the same vacuum deposition device at an oxygen partial pressure of $3.5 \times 10^{-3}$ Pa without bringing the pressure back to an atmospheric pressure, and SiO (purity of 99.9% or more) was heated and evaporated under a vacuum of $5 \times 10^{-3}$ Pa to form a PVD inorganic film ($SiO_x$) having a thickness of 40 nm on the CVD inorganic thin film surface.

Furthermore, on the side of the inorganic layer surface of the film obtained, the top coating agent obtained in Preparation Example 2 was applied by a gravure roll coating system with a wet thickness of 2.9 g/m$^2$ and at a film conveyance speed of 200 m/sec, and dried with a hot air of 90°C for 5 seconds to obtain a gas barrier film having a resin layer (a coating layer) of a thickness of 0.4 $\mu$m.

This film was subjected to an annealing treatment in a heating oven at 77 °C for 7 days. The gas barrier film obtained was subjected to various evaluations.

On the surface of the resultant resin film, an unstretched polypropylene film having a thickness of 60 $\mu$m ("Pylen Film CT P1146" manufactured by Toyobo Co., Ltd.) was laminated via a urethane-based adhesive ("AD900" (main agent) and "CAT-RT85" (curing agent) manufactured by Toyo-Morton, Ltd) to obtain a gas barrier laminate. The laminate was subjected to the water vapor transmission evaluations.

Table 2 show the results.

[Example 2]

Except that, in forming the inorganic layer of Example 1, the inorganic layer was made to be composed of only one PVD layer, a gas barrier film was prepared in the same manner as in Example 1 and subjected to various evaluations. Furthermore, from the gas barrier film prepared, a gas barrier laminate was prepared in the same manner as in Example 1 and subjected to evaluation of water vapor transmission rate measurement.

[Comparative Example 1]

Except that a resin layer was not formed and an annealing treatment was not performed, a gas barrier film was prepared in the same manner as in Example 1 and subjected to various evaluations. Furthermore, from the gas barrier film prepared, a gas barrier laminate was prepared in the same manner as in Example 1 and subjected to evaluation of water vapor transmission rate measurement.

[Comparative Example 2]

Except that an annealing treatment was not performed, a gas barrier film was prepared in the same manner as in Example 1 and subjected to various evaluations. Furthermore, from the gas barrier film prepared, a gas barrier laminate was prepared in the same manner as in Example 1 and subjected to evaluation of water vapor transmission rate measurement.

[Comparative Example 3]

Except that a resin layer was not formed, a gas barrier film was prepared in the same manner as in Example 1 and subjected to various evaluations. Furthermore, from the gas barrier film prepared, a gas barrier laminate was prepared in the same manner as in Example 1 and subjected to evaluation of water vapor transmission rate measurement.

[Comparative Example 4]

Except that, when forming the two PVD inorganic layers, oxygen was not introduced in each of them, a gas barrier film was prepared in the same manner as in Example 1 and subjected to various evaluations. Furthermore, from the gas barrier film prepared, a gas barrier laminate was prepared in the same manner as in Example 1 and subjected to evaluation of water vapor transmission rate measurement.

[Comparative Example 5]

Except that, when forming the two PVD inorganic layers, oxygen was not introduced in each of them and a resin layer was not formed, a gas barrier film was prepared in the same manner as in Example 1 and subjected to various evaluations. Furthermore, from the gas barrier film prepared, a gas barrier laminate was prepared in the same manner as in Example 1 and subjected to evaluation of water vapor transmission rate measurement.

[Example 3]

Except that, when forming the two PVD inorganic layers of Example 1, oxygen was introduced in each of them to an oxygen partial pressure of $3.9 \times 10^{-3}$ Pa, a gas barrier film was prepared in the same manner as in Example 1 and subjected to various evaluations. Furthermore, from the gas barrier film prepared, a gas barrier laminate was prepared in the same manner as in Example 1 and subjected to evaluation of water vapor transmission rate measurement.

[Example 4]

Except that, when forming the two PVD inorganic layers of Example 1, oxygen was introduced in each of them to an oxygen partial pressure of $1.6 \times 10^{-3}$ Pa, a gas barrier film was prepared in the same manner as in Example 1 and subjected to various evaluations. Furthermore, from the gas barrier film prepared, a gas barrier laminate was prepared in the same manner as in Example 1 and subjected to evaluation of water vapor transmission rate measurement.

[Comparative Example 6]

Except that, when forming the inorganic layer of Example 1, aluminum was evaporated under a vacuum of

$5\times10^{-3}$ Pa to form a thin film of aluminum oxide (alumina) of a thickness of about 40 nm, a gas barrier film was prepared in the same manner as in Example 1 and subjected to various evaluations. Furthermore, from the gas barrier film prepared, a gas barrier laminate was prepared in the same manner as in Example 1 and subjected to evaluation of water vapor transmission rate measurement.

Meanwhile, the following Table 1 shows an outline of the films of Examples 1 to 4 and Comparative Examples 1 to 6.

[Table 1]

| | Vapor-deposited layer | Oxygen partial pressure (Pa) | TC coating | Annealing temperature/time | a*value | b*value |
|---|---|---|---|---|---|---|
| Example 1 | Silicon oxide | $3.5\times10^{-3}$ | Present | 77°C 7days | 0.4 | 0.1 |
| Example 2 | Silicon oxide | $3.5\times10^{-3}$ | Present | 77°C 7days | -0.1 | 0.1 |
| Comparative Example 1 | Silicon oxide | $3.5\times10^{-3}$ | None | None | -0.2 | 2.1 |
| Comparative Example 2 | Silicon oxide | $3.5\times10^{-3}$ | Present | None | 1 | -1.4 |
| Comparative Example 3 | Silicon oxide | $3.5\times10^{-3}$ | None | 77°C 7days | -0.1 | 1.8 |
| Comparative Example 4 | Silicon oxide | 0 | Present | 77°C 7days | 1.5 | -1.6 |
| Comparative Example 5 | Silicon oxide | 0 | None | 77°C 7days | -0.8 | 4.7 |
| Example 3 | Silicon oxide | $3.9\times10^{-3}$ | Present | 77°C 7days | 0.9 | 0.2 |
| Example 4 | Silicon oxide | $1.6\times10^{-3}$ | Present | 77°C 7days | 0.6 | -0.9 |
| Comparative Example 6 | Aluminum oxide | $3.5\times10^{-3}$ | Present | 77°C 7days | 1.5 | -0.1 |

[Table 2]

| | Appearance | Haze (%) | Water vapor barrier 40°C90RH% g/m$^2$·24h·atm | Water vapor barrier 60°C90RH% g/m$^2$·24h·atm | Water vapor barrier 60°C90RH% | Background reflection |
|---|---|---|---|---|---|---|
| Example 1 | Good | 2.4 | 0.02 | 0.09 | Good | Good |
| Example 2 | Good | 2.6 | 0.05 | 0.20 | Good | Good |
| Comparative Example 1 | Good | 3.1 | 0.20 | - | - | Poor |
| Comparative Example 2 | Good | 2.7 | 0.03 | 0.10 | Good | Poor |
| Comparative Example 3 | Good | 3.2 | 0.15 | - | - | Poor |
| Comparative Example 4 | Poor | 2.6 | 0.05 | 0.18 | Good | Poor |

(continued)

|  | Appearance | Haze (%) | Water vapor barrier 40°C90RH% g/m$^2$•24h•atm | Water vapor barrier 60°C90RH% g/m$^2$•24h•atm | Water vapor barrier 60°C90RH% | Background reflection |
|---|---|---|---|---|---|---|
| Comparative Example 5 | Good | 2.6 | 0.12 | - | - | Poor |
| Example 3 | Good | 2.5 | 0.10 | 0.36 | Good | Fair |
| Example 4 | Fair | 3.0 | 0.07 | 0.25 | Good | Fair |
| Comparative Example 6 | Good | 2.5 | 0.05 | 0.50 | Poor | Poor |

As can be seen from Table 2, the gas barrier films obtained in Examples 1 and 2, compared to those obtained in Comparative Examples, have equal or better haze values and show more excellent water vapor barrier properties under both conditions of 40°C, 90% RH and 60°C, 90% RH. Also, the films of Examples 1 and 2 are "good" in background reflection and have no problem in appearance.

In Example 3, the amount of oxygen introduced when forming the inorganic layer was large, and its water vapor barrier property is inferior to Example 1. Furthermore, in Example 4, the amount of oxygen introduced when forming the inorganic layer was small, and defective portions in the coating occurred on the top coat, causing deterioration of the haze value and the water vapor barrier property compared to Example 1. When the a* value and b* value are concurrently in a range of -1 to 1, there is no problem in the visual check of the background reflection, showing good color tone and transparency.

Industrial Applicability

The gas barrier film of the present invention has a low haze value and excellent transparency and, at the same time, has an excellent water vapor barrier property even under the durability conditions of 60°C, 90% RH. Thus, the film is widely used in packaging of goods which need to shut off various gases such as water vapor, oxygen, and the like, for example, packaging for preventing deterioration of foods, industrial goods, drugs, and the like. In addition to the packaging use, in recent years, new use of the gas barrier plastic film is expected as a display protective sheet or a transparent conductive sheet used for liquid crystal display devices, solar cells, electromagnetic wave shields, touch panels, EL substrates, color filters and the like, and vacuum thermal insulation panels.

**Claims**

1. A gas barrier film comprising a resin layer disposed on an inorganic layer formed on at least one surface of a substrate film, the resin layer containing polyvinyl alcohol and a silicon compound, wherein b* and a* values of the film measured based on JIS Z8722 are -1.0 to 1.0 and -1.0 to 1.0, respectively,
   wherein the inorganic layer comprises at least one layer of a PVD inorganic layer formed by physical vapor deposition (PVD) in the presence of introduced oxygen,
   wherein the inorganic layer is composed of silicon oxide,
   wherein the haze value is 0.1 to 4.0% as determinded according to JIS K7136:2000,
   the gas barrier film has a water vapor transmission rate of less than 0.5 g/m$^2$/24 h/atm at 60°C, 90% RH.

2. The gas barrier film according to claim 1, wherein an anchor coat layer is formed on at least one surface of the substrate film.

3. The gas barrier film according to claim 1 or 2, wherein the water vapor transmission rate thereof is less than 0.3 g/m$^2$/24 h/atm at 60°C, 90% RH.

4. A gas barrier laminate comprising the gas barrier film according to any of claims 1 to 3 laminated with a transparent film and/or a low shrinkage film via an adhesive layer or a pressure-sensitive adhesive layer interposed therebetween.

5. A gas barrier laminate comprising at least one layer selected from a glare-proof layer, a low-reflection layer, and an glare-proof and low-reflection layer formed on at least one surface of the gas barrier laminate according to claim 4.

6. A protective sheet for a display, comprising the gas barrier laminate according to claim 5.

7. A method for producing a gas barrier film according to claims 1 to 3, comprising: forming an inorganic layer on at least one surface of a substrate film; and subsequently forming a resin layer containing polyvinyl alcohol and a silicon compound on the inorganic layer, wherein at least one layer of the inorganic layer is formed by a physical vapor deposition (PVD) method in the presence of introduced oxygen and, after forming the resin layer, an annealing treatment is performed,

wherein the pressure during formation of the PVD inorganic layer is $1 \times 10^{-7}$ to 1 Pa, wherein the oxygen partial pressure relative to the total pressure is 20 to 80%,
wherein the annealing treatment temperature is 60°C to 150°C, wherein the annealing treatment time is between 3 days to 6 months for 60°C, 3 hours to 10 days for 80°C, 1 hour to 1 day for 120°C, and 3 minutes to 60 minutes for 150°C.

## Patentansprüche

1. Gassperrfolie, umfassend eine Harzschicht, angeordnet auf einer anorganischen Schicht, die auf mindestens einer Oberfläche einer Substratfolie gebildet ist, wobei die Harzschicht Polyvinylalkohol und eine Siliziumverbindung enthält, worin b*- und a*-Werte der Folie, gemessen basierend auf JIS Z8722, -1,0 bis 1,0 bzw. -1,0 bis 1,0 betragen, wobei die anorganische Schicht mindestens eine Schicht aus einer anorganischen PVD-Schicht umfasst, gebildet durch physikalische Dampfabscheidung (PVD) in Gegenwart von zugeführtem Sauerstoff,
wobei die anorganische Schicht aus Siliziumoxid zusammengesetzt ist,
wobei der Trübungswert 0,1 bis 4,0 % beträgt, bestimmt gemäß JIS K7136:2000,
wobei die Gassperrfolie eine Wasserdampfdurchlässigkeitsrate von weniger als 0,5 $g/m^2$/24h/atm bei 60 °C, 90 % RH, aufweist.

2. Gassperrfolie nach Anspruch 1, wobei eine Ankerdeckschicht auf mindestens einer Oberfläche der Substratfolie gebildet ist.

3. Gassperrfolie nach Anspruch 1 oder 2, wobei die Wasserdampfdurchlässigkeitsrate hiervon weniger als 0,3 $g/m^2$/24h/atm bei 60 °C, 90 % RH, beträgt.

4. Gassperrlaminat, umfassend die Gassperrfolie nach irgendeinem der Ansprüche 1 bis 3, laminiert mit einer transparenten Folie und/oder einer Folie geringer Schrumpfung mittels einer Klebstoffschicht oder einer druckempfindlichen Klebstoffschicht, die dazwischen angeordnet ist.

5. Gassperrlaminat, umfassend mindestens eine Schicht, gewählt aus einer reflexfreien Schicht, einer niederreflektierenden Schicht und einer reflexfreien und niederreflektierenden Schicht, die auf mindestens einer Oberfläche des Gassperrlaminats nach Anspruch 4 gebildet ist.

6. Schutzfolie für ein Display, umfassend das Gassperrlaminat nach Anspruch 5.

7. Verfahren zur Herstellung einer Gassperrfolie nach den Ansprüchen 1 bis 3, umfassend:

Bilden einer anorganischen Schicht auf mindestens einer Oberfläche einer Substratfolie; und nachfolgend Bilden einer Harzschicht, enthaltend Polyvinylalkohol und eine Siliziumverbindung, auf der anorganischen Schicht, wobei mindestens eine Schicht der anorganischen Schicht durch ein physikalisches Dampfabscheidungs(PVD)-Verfahren in Gegenwart von zugeführtem Sauerstoff gebildet wird, und, nach dem Bilden der Harzschicht, eine Temperungsbehandlung durchgeführt wird,

wobei der Druck während Bildung der anorganischen PVD-Schicht $1 \times 10^{-7}$ bis 1 Pa beträgt, wobei der Sauerstoffpartialdruck relativ zu dem Gesamtdruck 20 bis 80 % beträgt,
wobei die Temperungsbehandlungstemperatur 60 °C bis 150 °C beträgt, wobei die Temperungsbehandlungszeit zwischen 3 Tagen bis 6 Monaten für 60 °C, 3 Stunden bis 10 Tagen für 80 °C, 1 Stunde bis 1 Tag für 120 °C und 3 Minuten bis 60 Minuten für 150 °C beträgt.

**Revendications**

1. Un film barrière aux gaz comprenant une couche de résine déposée sur une couche inorganique formée sur au moins une surface d'un film de substrat, la couche de résine contenant de l'alcool polyvinylique et un composé de silicium, dans lequel les valeurs b* et a* du film mesurées sur la base de JIS Z8722 sont de -1,0 à 1,0 et de -1,0 à 1,0, respectivement,
dans lequel la couche inorganique comprend au moins une couche d'une couche inorganique DPV formée par Dépôt physique par phase vapeur (DPV) ont la présence d'oxygène introduit,
dans lequel la couche n'ont organique est composée d'oxyde de silicium,
dans lequel une valeur de voile et de 0,1 à 4,0 % tel que déterminé selon JIS K 7136:2000,
le film barrière aux gaz à un taux de transmission de vapeur d'eau inférieur à 0,5 g / m² / 24 h / atm à 60 °C, 90 % HR.

2. Le film barrière aux gaz selon la revendication 1, dans lequel une couche de revêtement ancre est formée sur au moins une surface du film de substrat.

3. Le film barrière gaz selon la revendication 1 ou 2, dans lequel le taux de transmission de vapeur d'eau de celui-ci est inférieur à 0,3 g / m² / 24 h / atm à 60 °C, 90 % HR.

4. Un stratifié barrière aux gaz comprenant le film barrière aux gaz selon l'une quelconque des revendications 1 à 3 stratifié avec un film transparent et / ou un film à faible rétrécissement par le moyen d'une couche adhésive ou d'une couche adhésive sensible à la pression interposée entre ceux-ci.

5. Un stratifié barrière aux gaz comprenant au moins une couche choisie parmi une couche anti-éblouissement, une couche à faible réflexion et une couche anti-éblouissante et à faible réflexion formée sur au moins une surface du stratifié barrière aux gaz selon la revendication 4.

6. Une feuille de protection pour un affichage, comprenant le stratifié formant barrière aux gaz selon la revendication 5.

7. Un procédé de production d'un film barrière aux gaz selon les revendications 1 à 3, comprenant: la formation d'une couche inorganique sur au moins une surface d'un film de substrat; et former ensuite une couche de résine contenant de l'alcool polyvinylique et un composé de silicium sur la couche inorganique, au moins une couche de la couche inorganique étant formée par un procédé de dépôt physique en phase vapeur (DPV) en présence d'oxygène introduit et, après formation de la couche de résine, un traitement de recuit est effectué,
dans lequel la pression durant la formation de la couche inorganique est de 1 x 10$^{-7}$ à 1 Pa, dans lequel la pression partielle d'oxygène par rapport à la pression totale est de 20 à 80 %,
dans lequel la température de traitement de recuit et de 60 °C à 150 °C, dans lequel le temps de traitement de recuit est entre 3 jours à 6 mois pour 60 °C, 3 heures à 10 jours pour 80 °C, 1 heure 11 jours pour 120 °C, et 3 minutes à 60 minutes pour 150 °C.

## REFERENCES CITED IN THE DESCRIPTION

**Patent documents cited in the description**

- JP 2008036863 A
- EP 1941993 A1
- WO 9517349 A
- JP H616414 B